# FASCICULE DE BREVET EUROPEEN

(11) **EP 1 922 733 B1**
(45) Date de publication et mention de la délivrance du brevet: **06.05.2009**
(21) Numéro de dépôt: 06808064.7
(22) Date de dépôt: 05.09.2006
(51) Int. Cl.: G11C 11/24, G11C 11/401

(54) **CELLULE MEMOIRE VOLATILE REMANENTE**
REMANENTE FLÜCHTIGE SPEICHERZELLE
REMANENT VOLATILE MEMORY CELL

(30) Priorité: 08.09.2005 FR 0509141
(43) Date de publication de la demande: 21.05.2008
(73) Titulaire: STMicroelectronics SA, 92120 Montrouge (FR)
(72) Inventeur: RIZZO, Pierre, F-13100 Aix en Provence (FR); MOREAUX, Christophe, F-13109 Simiane (FR); NAURA, David, F-13100 Aix en Provence (FR); KARI, Ahmed, F-83170 Tourves (FR)
(74) Mandataire: Marchand, André
(86) Numéro de dépôt international: PCT/FR2006/002036
(87) Numéro de publication internationale: WO 2007/028888

(56) Documents cités:
- US-A- 4 982 363
- US-A- 5 623 442
- US-A- 5 706 225
- US-A1- 2001 028 575
- US-A1- 2002 005 536

## Description

La présente invention concerne une cellule mémoire volatile rémanente, pour mémoriser une donnée binaire pendant un temps de rétention indépendant d'une tension d'alimentation de la cellule mémoire.

Les circuits électroniques comportent généralement deux types de cellules mémoire : les cellules mémoire volatiles, utilisées pour réaliser des registres ou des plans mémoire RAM (Random Access Memory), et les cellules mémoire non volatiles, utilisées pour réaliser des registres ou des plans mémoire ROM (Read Only Memory), EPROM (Electrically Programmable Read Only Memory), EEPROM (Electrically Erasable and Programmable Read Only Memory), Flash, etc..

Une donnée enregistrée dans une cellule mémoire volatile est irrémédiablement perdue lorsque la tension d'alimentation de la cellule mémoire disparaît. Inversement, une donnée enregistrée dans une cellule mémoire non volatile est conservée quasi-indéfiniment indépendamment de la tension d'alimentation du circuit dans lequel la cellule mémoire est implantée.

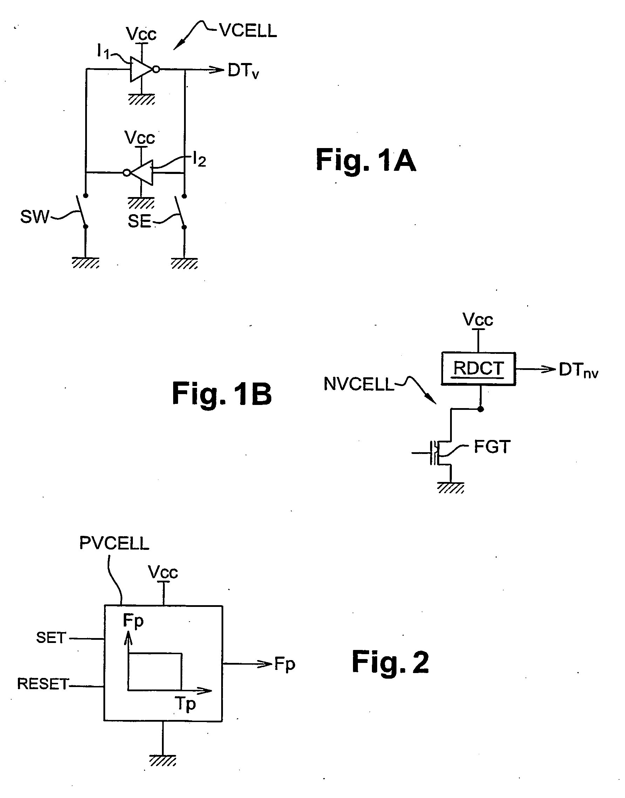

La figure 1A représente un exemple de réalisation d'une cellule mémoire volatile VCELL. La cellule mémoire comprend deux portes inverseuses I1, I2 agencées en boucle fermée, un interrupteur d'écriture SW et un interrupteur d'effacement SE permettant de charger dans la cellule une donnée DTv égale à 1 ou à 0. La donnée DTv est mémorisée par la cellule mémoire tant que les portes inverseuses reçoivent une tension Vcc, et s'efface lorsque la tension Vcc disparaît.

La figure 1B représente un exemple de réalisation d'une cellule mémoire non volatile NVCELL. La cellule comprend un transistor à grille flottante FGT et un circuit de lecture RDCT alimenté électriquement par une tension Vcc. La cellule mémoire est écrite en injectant des charges électriques dans la grille flottante du transistor, et est effacée en arrachant des charges électriques de la grille flottante. L'état passant ou non passant du transistor FGT, qui est fonction de la quantité de charges électriques piégée dans la grille flottante, est détecté par le circuit de lecture RDCT dont la sortie fournit une donnée DTnv. Si la tension d'alimentation Vcc disparaît, la donnée ne peut plus être lue mais l'état de la cellule mémoire demeure. La donnée DTnv peut donc de nouveau être lue lorsque la tension d'alimentation réapparaît.

La présente invention vise une cellule mémoire PVCELL représentée schématiquement en figure 2, qui n'appartient à aucune des catégories ci-dessus. La cellule mémoire PVCELL est alimentée électriquement par une tension Vcc et mémorise une donnée Fp dont la valeur peut être contrôlée au moyen d'un signal d'écriture SET et d'un signal d'effacement RESET. Une telle cellule mémoire présente les caractéristiques suivantes :
- lorsque la donnée est écrite, elle s'efface automatiquement au terme d'un laps de temps Tp appelé "temps de rétention", qui est indépendant de la tension Vcc et du signal d'effacement RESET,
- si la tension d'alimentation Vcc disparaît et réapparaît avant que le temps de rétention Tp n'ait expiré, la donnée Fp doit présenter, lorsque la tension Vcc réapparaît, la même valeur que celle qu'elle présentait avant que la tension Vcc ne disparaisse.

Une telle cellule mémoire est donc dite "rémanente" et "volatile", d'une part car elle présente un temps de rétention non nul pendant lequel elle ne perd pas la donnée qu'elle contient, y compris si la tension Vcc disparaît, et, d'autre part, car la donnée qu'elle contient s'évanouit lorsque le temps de rétention a expiré.

Une telle cellule mémoire est susceptible de diverses applications, notamment pour la conduite d'un processus nécessitant qu'un circuit électronique mémorise une donnée intervenant dans le contrôle du processus, et conserve cette donnée pendant un temps nécessaire à l'achèvement du processus, y compris si sa tension d'alimentation disparaît et réapparaît pendant la conduite du processus.

Le document US 5,706,225 divulgue une cellule mémoire comme indiqué dans le préambule de la revendication 1.

Le document US 4,982,363 divulgue un circuit détecteur-amplificateur qui module la valeur mémorisée en fonction de la tension fournit par la cellule mémoire.

Dans de telles applications, le temps de rétention visé est court, de l'ordre de quelques millisecondes à quelques centaines de secondes selon le cahier des charges du processus, et correspond sensiblement au temps d'exécution du processus.

Ainsi, un objectif de l'invention est de prévoir une structure de cellule mémoire volatile rémanente qui présente un temps de rétention court mais indépendant d'une tension d'alimentation.

Un objectif plus particulier de l'invention est de prévoir une structure de cellule mémoire volatile rémanente qui soit simple et de faible encombrement, et qui puisse être incorporée dans un circuit intégré de faible dimension, notamment un circuit intégré implanté sur une microplaquette de semi-conducteur d'une surface inférieure au millimètre carré.

Ces objectifs sont atteints par la prévision d'une cellule mémoire volatile rémanente comme définit par la revendication 1.

Selon un mode de réalisation, le circuit détecteur-amplificateur présente un seuil de commutation, la donnée binaire présente une valeur écrite lorsque la tension rémanente est supérieure au seuil de commutation et une valeur effacée lorsque la tension rémanente est inférieure au seuil de commutation, et le temps de décharge du point mémoire définit le temps de rétention de la donnée binaire en relation avec seuil de commutation.

Selon un mode de réalisation, le temps de décharge du point mémoire et le temps de rétention de la donnée binaire sont de l'ordre de quelques millisecondes à quelques centaines de secondes.

Selon un mode de réalisation, le circuit détecteur-amplificateur comprend un transistor de commutation ayant une borne de contrôle formant l'entrée du circuit détecteur-amplificateur et présentant une tension de seuil formant un seuil de commutation du circuit détecteur-amplificateur.

Selon un mode de réalisation, le transistor de commutation est un transistor MOS natif à faible tension de seuil.

Selon un mode de réalisation, le circuit détecteur-amplificateur comprend un étage d'entrée inverseur comprenant le transistor de commutation, et un étage de sortie inverseur dont l'entrée est connectée à un noeud de l'étage inverseur.

Selon un mode de réalisation, le circuit détecteur-amplificateur comprend un interrupteur piloté par le signal d'effacement et agencé pour imposer un potentiel électrique sur un noeud du circuit détecteur-amplificateur lorsque le signal d'effacement présente la valeur active, de manière que la donnée binaire soit forcée à la valeur effacée.

Selon un mode de réalisation, l'interrupteur pour provoquer la décharge du point mémoire est piloté par un signal de contre-réaction prélevé dans le circuit détecteur-amplificateur.

Selon un mode de réalisation, le point mémoire comprend une capacité électrique en parallèle avec une résistance.

Selon un mode de réalisation, la résistance du point mémoire est une résistance parasite d'un transistor MOS.

Selon un mode de réalisation, la résistance du point mémoire est une résistance parasite d'un transistor MOS formant ledit interrupteur pour provoquer la décharge du point mémoire.

Selon un mode de réalisation, la capacité du point mémoire est une capacité parasite de grille d'un transistor MOS.

Selon un mode de réalisation, la capacité du point mémoire est la capacité parasite de grille d'un transistor MOS du circuit détecteur-amplificateur recevant la tension rémanente sur sa borne de grille.

L'invention concerne également un circuit intégré comprenant au moins une cellule mémoire selon l'invention.

L'invention concerne également un circuit intégré sans contact alimenté électriquement par une tension continue générée à partir de signaux alternatifs fournis par un circuit d'antenne lorsque le circuit intégré se trouve en présence d'un champ d'activation, le circuit intégré comprenant au moins une cellule mémoire selon l'invention, pour mémoriser un drapeau pendant le temps de rétention y compris si la tension continue disparaît.

Selon un mode de réalisation, le circuit intégré comprend une unité de contrôle pour écrire le drapeau dans la cellule mémoire après que le circuit intégré a été identifié au cours d'une procédure d'inventaire, et ne plus répondre à une commande d'inventaire tant que le drapeau est écrit dans la cellule mémoire.

Ces objets, caractéristiques et avantages ainsi que d'autres de la présente invention seront exposés plus en détail dans la description suivante d'exemples de réalisation d'une cellule mémoire selon l'invention, faite à titre non limitatif en relation avec les figures jointes parmi lesquelles :
- les figures 1A et 1B précédemment décrites représentent schématiquement des cellules mémoire classiques,
- la figure 2 précédemment décrite représente schématiquement une cellule mémoire que l'invention vise à réaliser,
- la figure 3 représente la structure d'une cellule mémoire,
- la figure 4 représente une variante de réalisation de la cellule mémoire de la figure 3,
- la figure 5 représente une autre variante de réalisation de la cellule mémoire de la figure 3,
- la figure 6 représente une autre variante de réalisation de la cellule mémoire de la figure 3,
- la figure 7 représente un exemple de réalisation d'un générateur de courant représenté schématiquement sur les figures 3 à 6,
- les figures 8A à 8D sont des chronogrammes de signaux électriques illustrant le fonctionnement de la cellule mémoire selon l'invention,
- la figure 9 illustre une application de l'invention à la conduite d'un processus d'inventaire concernant des circuits intégrés sans contact, et
- la figure 10 représente schématiquement l'architecture d'un circuit intégré sans contact comprenant une cellule mémoire selon l'invention.

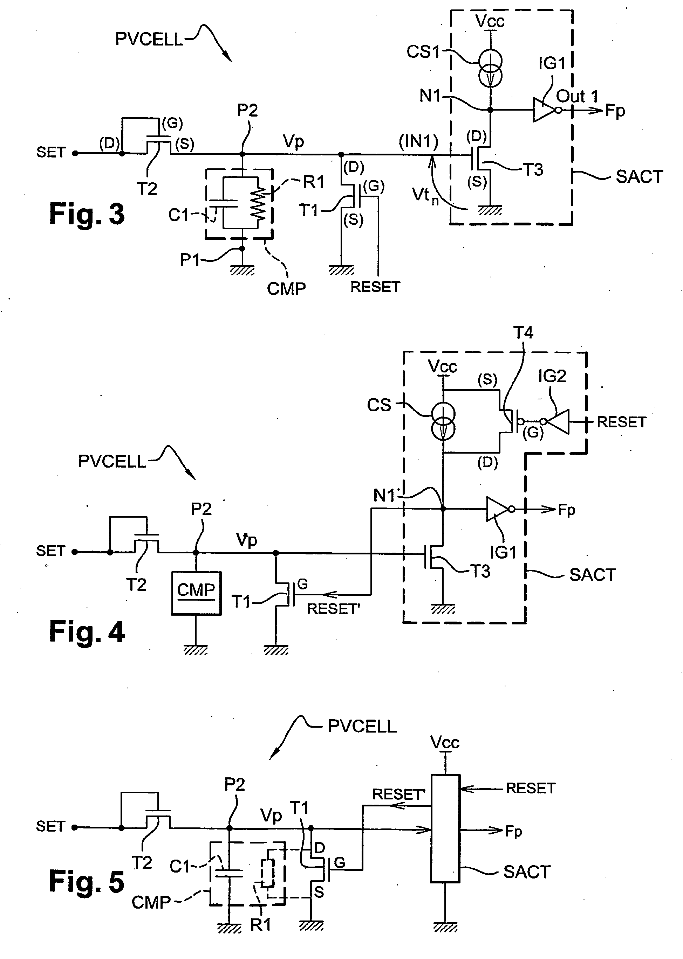

La figure 3 représente la structure générale d'une cellule mémoire PVCELL, prévue pour mémoriser une donnée, ici un bit Fp, pendant un temps de rétention Tp. La cellule mémoire est alimentée électriquement par une tension Vcc et reçoit un signal d'écriture SET et un signal d'effacement RESET. Le bit Fp, délivré par une sortie OUT1 de la cellule mémoire, peut présenter une valeur "écrite" et une valeur "effacée". Par convention, la valeur écrite est la valeur logique "1", la valeur "effacée" est valeur logique "0". Par convention toujours, la valeur active du signal SET est valeur logique "1" et la valeur active du signal RESET est également la valeur logique "1". Enfin, la valeur logique "1" correspond ici à la tension Vcc et la valeur logique "0" correspond au potentiel de la masse.

La cellule mémoire PVCELL telle que représentée comprend quatre principaux éléments :
- un point mémoire capacitif CMP qui fournit une tension Vp,
- un interrupteur T1 pour provoquer la décharge du point mémoire CMP lorsque le signal d'effacement RESET est mis à 1 (valeur active), et
- un interrupteur T2 pour provoquer la charge du point mémoire lorsque le signal d'écriture SET est mis à 1 (valeur active), et
- un circuit détecteur-amplificateur SACT ("Sense Amplifier Circuit") pour moduler la valeur du bit Fp en fonction de la valeur de la tension rémanente Vp.

Le point mémoire CMP comprend une capacité électrique C1 en parallèle avec une résistance R1, et présente une première borne P1 connectée à la masse et une seconde borne P2 connectée à l'entrée IN1 du circuit SACT et fournissant la tension Vp. L'homme de l'art notera que le terme "capacité" est préféré ici au terme "condensateur" car, comme cela sera vu plus loin, la capacité C1 peut être une capacité intrinsèque de composant électronique ne nécessitant pas la réalisation d'armatures de condensateur pour être utilisée en tant qu'élément du point mémoire.

L'interrupteur T1 est ici un transistor NMOS ayant une borne de source S connectée à la masse, une borne de drain D connectée à la borne P2 du point mémoire, et une borne de grille recevant le signal RESET.

L'interrupteur T2 est également un transistor NMOS et est agencé pour appliquer la tension Vcc à la borne P2 du point mémoire lorsque le signal SET est égal à 1. Comme représenté, le transistor T2 a sa borne de source S connectée à la borne P2 du point mémoire, sa borne de grille G connectée à sa borne de drain D sur laquelle est appliqué le signal SET. Cet agencement en transistor-diode du transistor T2 laisse passer la tension Vcc quand le signal SET est égal à 1 (1=Vcc).

Lorsque le signal SET est égal à 1, la borne P2 du point mémoire reçoit la tension Vcc et la capacité C1 se charge en accumulant des charges électriques, jusqu'à ce que la tension Vp soit égale à la tension Vcc (en négligeant la chute de tension aux bornes du transistor T2).

Lorsque le signal SET passe à 0 et que le signal RESET est maintenu à 0, la capacité C1 se décharge lentement à travers la résistance R1, qui forme ainsi une résistance de fuite du point mémoire. La tension Vp diminue progressivement et tend vers le potentiel 0, suivant un temps de décharge qui est déterminé par la constante RC du point mémoire.

Si le signal RESET est mis à 1 avant que le temps de rétention Tp n'ait expiré, l'interrupteur T1 devient passant et les bornes P1, P2 du point mémoire CMP sont court-circuitées. La capacité C1 se décharge très vite à travers le transistor T1 et la tension Vp devient nulle de façon quasi-instantanée.

Les variations de la tension Vp sont détectées par le circuit SACT, qui reçoit la tension Vp sur une entrée IN1 et fournit le bit Fp à la sortie OUT1 de la cellule mémoire. Le circuit SACT comprend ici un étage d'entrée inverseur, comprenant une source de courant CS en série avec un transistor T3 de type NMOS, et un étage de sortie inverseur qui fournit le bit Fp. Dans l'étage d'entrée, la source de courant CS a une entrée polarisée par la tension Vcc et une sortie connectée à la borne de drain D du transistor T3, dont la borne de source S est connectée à la masse. La borne de grille G du transistor T3 forme l'entrée IN1 du circuit SACT et reçoit ainsi la tension Vp. L'étage de sortie est ici une porte inverseuse IG1 ayant son entrée connectée à un noeud N1 de l'étage d'entrée, ici le noeud reliant la sortie du générateur de courant CS à la borne de drain D du transistor T3.

Le circuit SACT présente un seuil de déclenchement inférieur à la tension Vcc, qui est ici égal à la tension de seuil Vtn du transistor d'entrée T3. Ce seuil est par exemple égal à 0,2 V et la tension Vcc égale à 1,8 V. Ainsi, lorsque le signal SET est mis à 1 et que la tension Vp est portée à la tension Vcc, dépassant ainsi le seuil Vtn, le transistor T3 devient passant. La source de courant CS impose dans l'étage d'entrée un courant faible relativement à la conductance du transistor de T3, de sorte que la tension de drain D du transistor T3, soit la tension du noeud N1, diminue jusqu'à une valeur inférieure à un seuil de déclenchement de la porte IG1. La porte IG1 voit ainsi un "0" sur son entrée et le bit Fp passe à 1.

Lorsque la tension Vp devient inférieure au seuil Vtn, le transistor T3 se bloque et le noeud N1 remonte au potentiel Vcc grâce au courant fourni par la source CS. La porte IG1 change d'état et le bit Fp passe à 0 (valeur effacée).

Ainsi, conformément aux objectifs de l'invention, la donnée Fp est effacée dans l'un ou l'autre des cas suivants :
- lorsque le temps de rétention Tp a expiré, c'est-à-dire lorsque la capacité C1 est suffisamment déchargée pour que la tension Vp soit inférieure au seuil Vtn, ou
- lorsque le signal RESET est mis à 1 avant que le temps de rétention Tp n'ait expiré (dans le cas contraire, la donnée est déjà égale à 0).

Le temps de rétention Tp est égal ici au temps s'écoulant entre l'instant où la tension Vp est égale à Vcc et l'instant où la tension Vp devient inférieure au seuil Vtn. Afin de maximaliser ce temps pour une constante de temps RC donnée, le transistor T3 est de préférence un transistor natif (sans dopage de sa région de canal) ayant une tension de seuil Vtn faible.

Sur la figure 4, la structure de la cellule mémoire est optimisée pour présenter un temps d'effacement court lorsque le signal RESET est mis à 1. A cet effet, un transistor T4 de type PMOS est agencé en parallèle avec la source de courant CS, sa borne de source S recevant la tension Vcc et sa borne de drain D étant connectée au noeud N1. La borne de grille G du transistor T4 est pilotée par la sortie d'une porte inverseuse IG2 qui reçoit le signal RESET.

Ainsi, lorsque le signal RESET est mis à 1, la sortie de la porte IG2 passe à 0, le transistor PMOS T4 devient passant et court-circuite le générateur de courant CS en imposant de façon quasi instantanée la tension Vcc sur le noeud N1, de sorte que la donnée Fp passe immédiatement à 0.

Par ailleurs, sur la figure 4, la borne de grille G du transistor T1 est pilotée par un signal de contre-réaction RESET' qui est prélevé sur le noeud N1 du circuit SACT. Ainsi, lorsque la cellule mémoire est forcée à 0 au moyen du signal RESET et que le noeud N1 monte à la tension Vcc, le signal RESET' recopie le signal RESET et le transistor T1 devient passant, déchargeant ainsi le point mémoire. L'effet de contre-réaction intervient lorsque le point mémoire capacitif se décharge naturellement, sans intervention du signal RESET : lorsque la tension Vp atteint le seuil Vt et que le transistor T2 commence à se bloquer, la tension du noeud N1 monte vers Vcc et rend le transistor T1 passant, ce qui accélère la décharge du point mémoire capacitif et permet d'obtenir un basculement franc de la cellule mémoire.

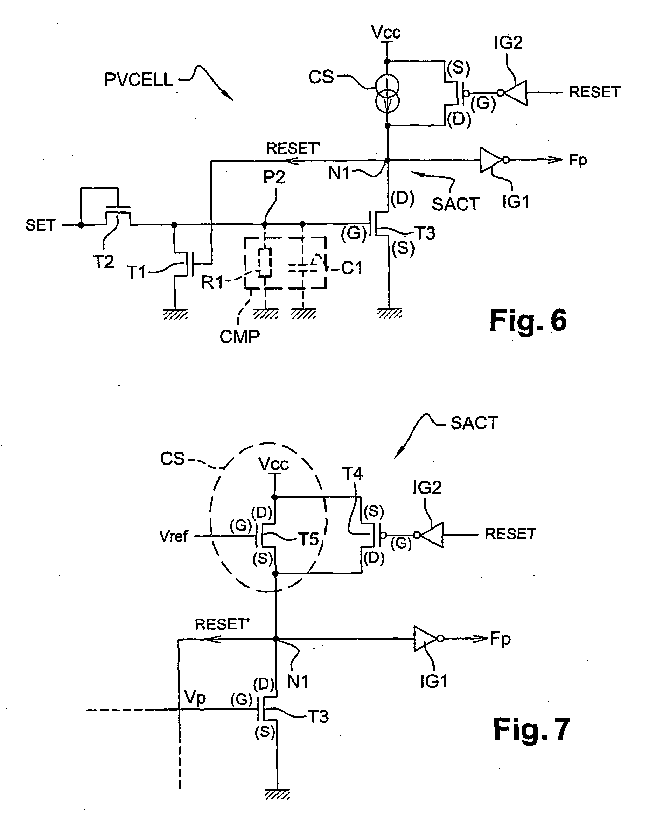

Les figures 5 et 6 illustrent deux aspects de l'invention permettant de réduire considérablement l'encombrement de la cellule mémoire PVCELL, en termes de surface de semi-conducteur occupée.

Sur la figure 5, la résistance R1 du point mémoire CMP est avantageusement la résistance intrinsèque drain-source (RDSoff) du transistor T1 dans l'état non passant. Une telle résistance présente une valeur élevée, généralement plusieurs centaines voire quelques milliers de Giga ohms (10⁹ Ω). Etant donné que le temps de rétention Tp visé par l'invention doit être de l'ordre de quelques millisecondes à quelques centaines de secondes (selon le cahier des charges du processus nécessitant l'utilisation de la donnée Fp), l'utilisation d'une telle résistance parasite pour fixer la constante de temps RC du point mémoire est avantageuse à plusieurs titres. D'une part, il n'est pas nécessaire d'implanter une résistance spécifique sur un substrat semi-conducteur, d'autre part la forte valeur de cette résistance est telle que la capacité C1 peut être de faible valeur, et par conséquent de faible surface.

La figure 6 représente un mode de réalisation préféré de la cellule mémoire PVCELL qui met en oeuvre les aspects de l'invention décrits en relation avec les figures 4 et 5. De plus, ici, la capacité C1 du point mémoire est avantageusement la capacité parasite grille-source du transistor T3. Ainsi, le point mémoire CMP n'est formé que par des éléments C1, R1 intrinsèques (représentés pour cette raison en traits pointillés) qui occupent une surface de semi-conducteur nulle en tant que tels, en sus de la surface occupée par les transistors T1 et T3.

A titre d'exemple numérique, en dimensionnant le transistor T3 pour qu'il présente une capacité grille-source de quelques pico Farad, par exemple 10 pF (10 10⁻¹² F), et en dimensionnant le transistor T1 pour qu'il présente une résistance drain-source de 10¹² Ω, le point mémoire présente une constante de temps de l'ordre de 10 secondes.

Un exemple de réalisation de la source de courant CS est illustré sur la figure 7. La source de courant est formée par un transistor NMOS T5 ayant sa borne de source S connectée à la borne de drain D du transistor T3 (noeud N1), sa borne de drain D polarisée par la tension Vcc et sa borne de grille polarisée par une tension de référence Vref. La tension Vref est par exemple générée au moyen d'un étage de contrôle en miroir de courant (non représenté) ou au moyen d'un générateur de tension de bandgap.

Il apparaîtra clairement à l'homme de l'art que les éléments constitutifs de la cellule mémoire selon l'invention sont susceptibles de diverses variantes de réalisation et perfectionnements, notamment la structure du point mémoire CMP et la structure du circuit détecteur-amplificateur, qui ont été conçus ici pour être de structure simple et comprendre un minimum de composants. Par ailleurs, le point mémoire CMP peut être chargé à la tension Vcc de diverses autres manières, en réponse au passage à 1 du signal SET. Le signal SET peut par exemple être appliqué sur la borne de grille G du transistor T2 et la tension Vcc être appliquée continuellement sur la borne de drain D de ce transistor. La charge du point mémoire peut également être faite au moyen d'une tension spécifique différente de la tension Vcc.

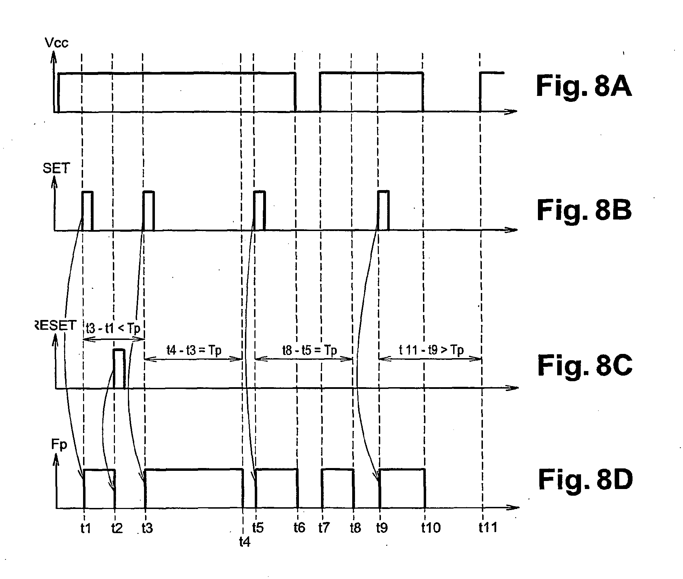

Les figures 8A à 8D illustrent le fonctionnement de la cellule mémoire selon l'invention. La figure 8A représente des fluctuations de la tension Vcc, la figure 8B représente des variations du signal d'écriture SET et la figure 8B représente des variations du signal d'effacement RESET.

Dans l'exemple représenté, la tension Vcc disparaît à un instant t6, réapparaît à un instant t7, disparaît de nouveau à un instant t10 et réapparaît à un instant t11. Le signal SET est mis fugitivement à 1 à des instants t1, t3, t5, t9 et le signal RESET est mis fugitivement à 1 à un instant t2.

La figure 8D représente l'aspect du bit Fp fourni par la cellule mémoire. On observe les variations suivantes :
1) le bit Fp passe à 1 à l'instant t1 (SET=1) et passe à 0 à l'instant t2 car le signal RESET est mis à 1 avant que le temps de rétention Tp n'ait expiré (t2-t1 < Tp),
2) le bit Fp passe à 1 à l'instant t3 (SET=1) et passe à 0 à un instant t4 lorsque le temps de rétention Tp a expiré (t4-t3 = Tp),
3) le bit Fp passe à 1 à l'instant t5 (SET=1), puis passe à 0 à l'instant t6 car la tension Vcc disparaît (le circuit détecteur-amplificateur SACT ne fonctionne plus), puis passe à 1 à l'instant t7 lorsque la tension Vcc réapparaît, car le temps de rétention Tp n'a pas expiré, puis passe à 0 à un instant t8 lorsque le temps de rétention a expiré (t8 -t5 = Tp),
4) le bit Fp passe à 1 à l'instant t9 (SET=1) puis passe à 0 à l'instant t10 car la tension Vcc disparaît, et reste à 0 à l'instant t11, lorsque la tension Vcc réapparaît, car le temps de rétention Tp a expiré (t11 - t9 > Tp), le point mémoire capacitif étant déchargé en dessous du seuil Vtn.

Comme indiqué plus haut, la cellule mémoire selon l'invention est susceptible de diverses applications et notamment le contrôle d'un processus au cours duquel la tension d'alimentation Vcc de la cellule mémoire peut disparaître temporairement, comme cela vient d'être décrit.

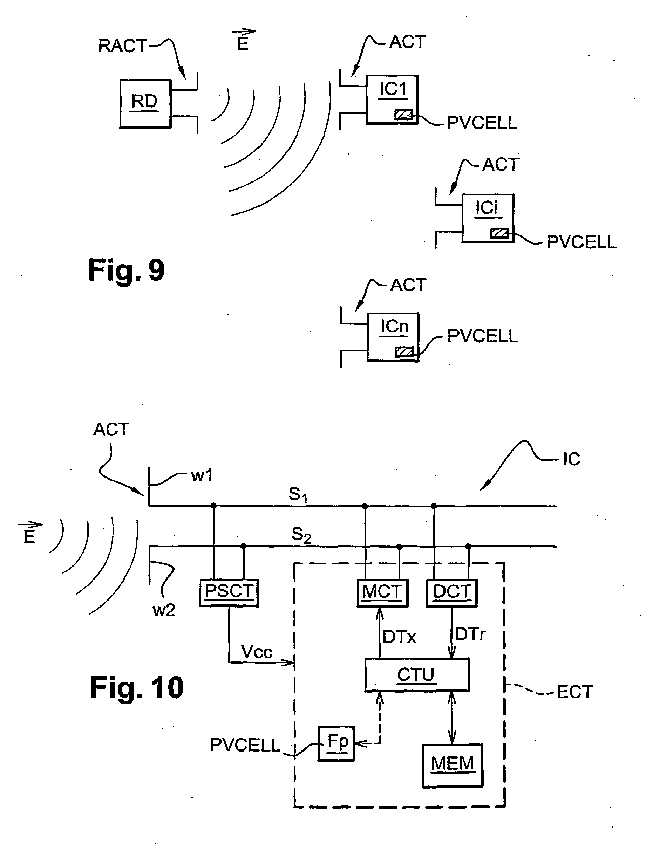

La figure 9 illustre une application de l'invention à la conduite d'un processus d'inventaire concernant une pluralité de circuits intégrés sans contact IC (IC1,...ICi,...ICn). L'inventaire est réalisé par un lecteur RD (lecteur de circuit intégré sans contact) équipé d'un circuit d'antenne RACT au moyen duquel le lecteur émet un champ d'activation, ici un champ électrique E. Le champ d'activation permet d'alimenter électriquement les circuits intégrés, d'envoyer des commandes aux circuits intégrés et de recevoir des réponses émises par les circuits intégrés.

Chaque circuit intégré IC est équipé d'un circuit d'antenne ACT et est alimenté électriquement à partir de signaux d'antenne induits par le champ électrique E. Chaque circuit intégré IC comprend au moins une cellule mémoire PVCELL selon l'invention. Le bit Fp mémorisé par la cellule PVCELL est utilisé en tant que drapeau d'inventaire.

L'inventaire est déclenché lorsque le lecteur RD envoi une commande d'inventaire ("INVENTORY") à l'ensemble des circuits intégrés présents dans le champ d'activation. En réponse à la commande d'inventaire, chaque circuit intégré répond en envoyant un message d'identification comprenant un identifiant unique (par exemple un numéro de série) tout en respectant un protocole anticollision permettant d'éviter, sinon de limiter, des collisions entre messages d'identification. Par exemple, chaque circuit intégré choisit une position de réponse aléatoire sur une échelle temporelle de réponse dont l'étendue est fixée par la commande d'inventaire.

Afin de permettre l'inventaire complet de l'ensemble des circuits intégrés présents dans le champ d'activation tout en limitant le nombre de collisions, il est souhaitable qu'un circuit intégré ayant été identifié ne réponde pas à une nouvelle commande d'inventaire, que le lecteur peut être conduit à émettre si des collisions entre réponses ne lui permettent pas d'identifier tous les circuits intégrés.

Ainsi, lorsqu'un circuit intégré IC sait qu'il a été inventorié, c'est-à-dire lorsqu'il a reçu du lecteur RD un accusé de réception confirmant que son message d'identification a été correctement lu, il met à 1 son drapeau d'inventaire Fp et le conserve pendant le temps de rétention Tp, lequel étant choisi suffisamment long pour permettre le bouclage du processus d'inventaire. Tant que le drapeau est à 1, le circuit intégré ne répond pas à de nouvelles commandes d'inventaires. Lorsque le temps qui s'est écoulé entre l'instant où un circuit intégré a été inventorié et l'instant où il reçoit une nouvelle commande d'inventaire est supérieur au temps de rétention du drapeau Fp, le circuit intégré répond à la nouvelle commande d'inventaire car le drapeau Fp est redevenu égal à 0.

Toutefois, dans une telle application, la distance entre les circuits intégrés IC et le lecteur RD n'est pas toujours maîtrisée, chaque circuit intégré étant solidaire d'un objet mobile (étiquette électronique, carte à puce, badge...) qui est susceptible d'être amené hors du champ d'activation puis d'être remis dans le champ d'activation. Ainsi, un circuit intégré peut perdre temporairement sa tension d'alimentation et la retrouver avant que le processus d'inventaire ne soit achevé.

Grâce à la cellule mémoire PVCELL selon l'invention, un circuit intégré qui est sorti du champ d'activation et est remis dans le champ d'activation avant que le processus d'inventaire ne soit achevé, est en mesure de savoir, lorsqu'il se "réveille" (réapparition de sa tension d'alimentation), qu'il a été récemment inventorié, de sorte qu'il ne répond pas à une nouvelle commande d'inventaire.

La figure 10 représente un exemple de réalisation d'un circuit intégré IC prévu pour cette application. Le circuit intégré comprend :
1) un circuit d'antenne ACT comportant les conducteurs W1, W2,
2) un circuit d'alimentation PSCT fournissant une tension d'alimentation Vcc, et
3) un circuit électronique ECT alimenté électriquement par la tension Vcc, implémentant des fonctionnalités de transpondeur.

Le circuit électronique ECT comprend un circuit modulateur MCT et un circuit démodulateur DCT reliés au circuit d'antenne ACT, une unité de contrôle CTU, une mémoire non volatile MEM, par exemple une mémoire EEPROM, et une cellule mémoire volatile rémanente PVCELL selon l'invention (plusieurs cellules pouvant également être prévue pour former un registre selon l'invention).

En présence du champ électrique E émis par le lecteur RD (fig. 9), des signaux d'antenne S1, S2 apparaissent dans les conducteurs W1, W2 et activent le circuit d'alimentation PSCT. Celui-ci fournit alors la tension Vcc et le circuit intégré bascule de l'état hors tension à l'état activé.

Le lecteur RD envoie des données DTr au circuit intégré en modulant le champ électrique E, par exemple en modulant l'amplitude du champ électrique. La modulation d'amplitude se répercute sur les signaux d'antenne S1, S2. Le circuit DCT démodule les signaux S1, S2 et fournit à l'unité CTU les données DTr qui sont véhiculées par ces signaux. De son côté, l'unité de contrôle CTU envoie des données DTx au lecteur au moyen du circuit MCT, qui module l'impédance du circuit d'antenne ACT en fonction de ces données. Une telle modulation d'impédance se répercute dans le circuit d'antenne du lecteur RD, et celui-ci en déduit les données DTx.

Grâce à ces divers éléments, l'unité CTU est en mesure de recevoir et d'exécuter des commandes envoyées par le lecteur RD, notamment des commandes de lecture ou d'écriture de la mémoire MEM, ainsi que la commande INVENTORY. Plus particulièrement, lorsque l'unité CTU a répondu à une commande d'inventaire et qu'elle reçoit un accusé de réception du lecteur, l'unité CTU met à 1 le drapeau Fp et ne répond plus à la commande d'inventaire tant que le drapeau Fp est égal à 1.

L'architecture du circuit intégré IC, en soi connue de l'homme de l'art, ne sera pas décrite plus en détail. Le circuit intégré IC peut par exemple être réalisé conformément aux spécifications industrielles EPCTM-GEN2 ("*Radio-Frequency Identity Protocols Class-1 Generation-2 - UHF RFID Protocol for Communications at 860 MHz - 960 MHz*") en cours de normalisation.

Les circuits intégrés sans contact du type de celui qui vient d'être décrit sont généralement appelés des circuits intégrés RFID (Radio Frequency Identification) et permettent de réaliser divers objets portatifs électroniques fonctionnant sans contact, comme des étiquettes électroniques ou des cartes à puce sans contact, notamment des porte-monnaies électroniques, des cartes de contrôle d'accès, des cartes de transport...

L'invention s'applique à tout type de circuit intégré sans contact passif utilisant un champ d'activation pour produire une tension d'alimentation. Ce champ d'activation peut être un champ électrique, comme décrit plus haut, mais peut aussi être un champ magnétique. Ainsi, l'invention s'applique également aux circuits intégrés sans contact comprenant une bobine d'antenne, notamment des circuits dits "PICC" ("Proximity Inductive Coupling Circuits" ou "circuits à couplage inductif de proximité") conformes à l'une des normes ISO/IEC 14443A/B, ISO/IEC 13693.

## Revendications

1. Cellule mémoire volatile rémanente (PVCELL), pour mémoriser une donnée binaire (Fp) pendant un temps de rétention (Tp) indépendant d'une tension (Vcc) d'alimentation de la cellule mémoire, comprenant :
- un point mémoire capacitif (CMP, C1, R1) fournissant une tension rémanente (Vp) et comportant une résistance de fuite (R1) pour présenter un temps de décharge,
- un interrupteur (T2) pour provoquer la charge du point mémoire lorsqu'un signal d'écriture (SET) présente une valeur active,
**caractérisée en ce qu'**elle comprend :
- un circuit détecteur-amplificateur (SACT) comprenant une entrée (IN1) recevant la tension rémanente (Vp) et modulant la valeur donnée binaire (Fp) en fonction de la valeur de la tension rémanente (Vp), et
- un interrupteur (T1) pour provoquer la décharge du point mémoire lorsqu'un signal d'effacement (RESET) présente une valeur active, piloté par un signal de contre-réaction (RESET') prélevé dans le circuit détecteur-amplificateur (SA).

2. Cellule mémoire selon la revendication 1, dans laquelle :
- le circuit détecteur-amplificateur (SACT) présente un seuil de commutation (Vtn),
- la donnée binaire présente une valeur écrite (1) lorsque la tension rémanente (Vp) est supérieure au seuil de commutation (Vtn) et une valeur effacée (0) lorsque la tension rémanente est inférieure au seuil de commutation, et
- le temps de décharge du point mémoire (CMP, C1, R1) définit le temps de rétention (Tp) de la donnée binaire (Fp) en relation avec seuil de commutation (Vtn).

3. Cellule mémoire selon l'une des revendications 1 et 2, dans laquelle le temps de décharge du point mémoire (CMP, C1, R1) et le temps de rétention (Tp) de la donnée binaire (Fp) sont de l'ordre de quelques millisecondes à quelques centaines de secondes.

4. Cellule mémoire selon l'une des revendications 1 à 3, dans laquelle le circuit détecteur-amplificateur (SACT) comprend un transistor de commutation (T3) ayant une borne de contrôle (G) formant l'entrée (IN1) du circuit détecteur-amplificateur et présentant une tension de seuil (Vtn) formant un seuil de commutation du circuit détecteur-amplificateur (SACT).

5. Cellule mémoire selon la revendication 4, dans laquelle le transistor de commutation est un transistor MOS natif à faible tension de seuil (Vtn).

6. Cellule mémoire selon l'une des revendications 4 et 5, dans lequel le circuit détecteur-amplificateur (SACT) comprend un étage d'entrée inverseur comprenant le transistor de commutation (T3), et un étage de sortie inverseur (IG1) dont l'entrée est connectée à un noeud (N1) de l'étage inverseur.

7. Cellule mémoire selon l'une des revendications 1 à 6, dans laquelle le circuit détecteur-amplificateur (SACT) comprend un interrupteur (T4, IG2) piloté par le signal d'effacement (RESET) et agencé pour imposer un potentiel électrique (Vcc) sur un noeud (N1) du circuit détecteur-amplificateur lorsque le signal d'effacement (RESET) présente la valeur active, de manière que la donnée binaire (Fp) soit forcée à la valeur effacée.

8. Cellule mémoire selon l'une des revendications 1 à 7, dans laquelle le point mémoire (CMP) comprend une capacité électrique (C1) en parallèle avec une résistance (R1).

9. Cellule mémoire selon la revendication 7, dans laquelle la résistance (R1) du point mémoire est une résistance parasite d'un transistor MOS (T1).

10. Cellule mémoire selon l'une des revendications 8 et 9, dans laquelle la résistance (R1) du point mémoire est une résistance parasite d'un transistor MOS (T1) formant ledit interrupteur pour provoquer la décharge du point mémoire.

11. Cellule mémoire selon l'une des revendications 8 à 10, dans laquelle la capacité (C1) du point mémoire est une capacité parasite de grille d'un transistor MOS (T3).

12. Cellule mémoire selon l'une des revendications 8 à 11, dans laquelle la capacité du point mémoire est la capacité parasite de grille d'un transistor MOS (T3) du circuit détecteur-amplificateur (SA) recevant la tension rémanente (Vp) sur sa borne de grille.

13. Circuit intégré, **caractérisé en ce qu'**il comprend au moins une cellule mémoire selon l'une des revendications 1 à 12.

14. Circuit intégré sans contact (IC, IC1-ICn) alimenté électriquement par une tension continue (Vcc) générée à partir de signaux alternatifs (S1, S2) fournis par un circuit d'antenne (ACT, W1, W2) lorsque le circuit intégré se trouve en présence d'un champ d'activation (E), **caractérisé en ce qu'**il comprend au moins une cellule mémoire (PVCELL) selon l'une des revendications 1 à 12, pour mémoriser un drapeau (Fp) pendant le temps de rétention (Fp) y compris si la tension continue (Vcc) disparaît.

15. Circuit intégré sans contact selon la revendication 14, comprenant une unité de contrôle (CTU) pour écrire le drapeau dans la cellule mémoire (PVCELL) après que le circuit intégré a été identifié au cours d'une procédure d'inventaire, et ne plus répondre à une commande d'inventaire (INVENTORY) tant que le drapeau est écrit dans la cellule mémoire.

## Claims

1. Persistent volatile memory cell (PVCELL), to memorize a binary data (Fp) during a retention time (Tp) independent of a supply voltage (Vcc) of the memory cell, comprising:
- a capacitive memory point (CMP, C1, R1) supplying a persistent voltage (Vp) and comprising a leakage resistance (R1) to have a discharge time,
- a switch (T2) to trigger the charge of the memory point when a write signal (SET) has an active value,
**characterised in that** it comprises:
- a sense-amplifier circuit (SACT) comprising an input (IN1) receiving the persistent voltage (Vp) and modulating the value of the binary data (Fp) according to the value of the persistent voltage (Vp), and
- a switch (T1) to trigger the discharge of the memory point when an erase signal (RESET) has an active value, driven by a feedback signal (RESET') taken from the sense-amplifier circuit (SA).

2. Memory cell according to claim 1, wherein:
- the sense-amplifier circuit (SACT) has a switching threshold (Vtn),
- the binary data has a written value (1) when the persistent voltage (Vp) is greater than the switching threshold (Vtn) and an erased value (0) when the persistent voltage is lower than the switching threshold, and
- the discharge time of the memory point (CMP, C1, R1) defines the retention time (Tp) of the binary data (Fp) in relation with the switching threshold (Vtn).

3. Memory cell according to one of claims 1 and 2, wherein the discharge time of the memory point (CMP, C1, R1) and the retention time (Tp) of the binary data (Fp) are around some milliseconds to some hundreds of seconds.

4. Memory cell according to one of claims 1 to 3, wherein the sense-amplifier circuit (SACT) comprises a switching transistor (T3) having a control terminal (G) forming the input (IN1) of the sense-amplifier circuit and having a threshold voltage (Vtn) forming a switching threshold of the sense-amplifier circuit (SACT).

5. Memory cell according to claim 4, wherein the switching transistor is a native MOS transistor with low threshold voltage (Vtn).

6. Memory cell according to one of claims 4 and 5, wherein the sense-amplifier circuit (SACT) comprises an inverter input stage comprising the switching transistor (T3), and an inverter output stage (IG1) which input is connected to a node (N1) of the inverter stage.

7. Memory cell according to one of claims 1 to 6, wherein the sense-amplifier circuit (SACT) comprises a switch (T4, IG2) driven by the erase signal (RESET) and arranged to impose an electrical potential (Vcc) to a node (N1) of the sense-amplifier circuit when the erase signal (RESET) has the active value, so that the binary data (Fp) is forced to the erased value.

8. Memory cell according to one of claims 1 to 7, wherein the memory point (CMP) comprises an electrical capacitance (C1) in parallel with a resistance (R1).

9. Memory cell according to claim 7, wherein the resistance (R1) of the memory point is a parasitic resistance of a MOS transistor (T1).

10. Memory cell according to one of claims 8 and 9, wherein the resistance (R1) of the memory point is a parasitic resistance of a MOS transistor (T1) forming said switch to trigger the discharge of the memory point.

11. Memory cell according to one of claims 8 to 10, wherein the capacitance (C1) of the memory point is a parasitic gate capacitance of a MOS transistor (T3).

12. Memory cell according to one of claims 8 to 11, wherein the capacitance of the memory point is the parasitic gate capacitance of a MOS transistor (T3) of the sense-amplifier circuit (SA) receiving the persistent voltage (Vp) on the gate terminal thereof.

13. Integrated circuit **characterised in that** it comprises at least one memory cell according to one of claims 1 to 12.

14. Contactless integrated circuit (IC, IC1-ICn) electrically powered by a direct voltage (Vcc) generated from alternative signals (S1, S2) supplied by an antenna circuit (ACT, W1, W2) when the integrated circuit is in the presence of an activation field (E), **characterised in that** it comprises at least one memory cell (PVCELL) according to one of claims 1 to 12, to memorize a flag (Fp) during the retention time (Fp), included if the direct voltage (Vcc) disappears.

15. Contactless integrated circuit according to claim 14, comprising a control unit (CTU) to write the flag in the memory cell (PVCELL) after the integrated circuit being identified during an inventory procedure, and not to answer any longer to an inventory command (INVENTORY) as long as the flag is written in the memory cell.

## Patentansprüche

1. Flüchtige remanente Speicherzelle (PVCELL), zum Speichern einer binären Information (Fp) während einer Haltezeit (Tp), die von einer Versorgungsspannung (Vcc) der Speicherzelle unabhängig ist, Folgendes aufweisend:
- einen kapazitiven Speicherpunkt (CMP, C1, R1), der eine remanente Spannung (Vp) liefert und einen Ableitwiderstand (R1) aufweist, um eine Entladezeit aufzuweisen,
- einen Schalter (T2) zum Auslösen des Ladens des Speicherpunkts, wenn ein Schreibsignal (SET) einen aktiven Wert aufweist,
**dadurch gekennzeichnet, dass** sie Folgendes aufweist:
- einen Detektor-Verstärkerschaltkreis (SACT), der einen Eingang (IN1) aufweist, der die remanente Spannung (Vp) empfängt und den gegebenen binären Wert (Fp) in Abhängigkeit von dem Wert der remanenten Spannung (Vp) moduliert, und
- einen Schalter (T1) zum Auslösen des Entladens des Speicherpunkts, wenn ein Löschsignal (RESET) einen aktiven Wert aufweist, gesteuert von einem Gegenreaktionssignal (RESET'), das aus dem Detektor-Verstärkerschaltkreis (SA) entnommen wird.

2. Speicherzelle nach Anspruch 1, bei der:
- der Detektor-Verstärkerschaltkreis (SACT) einen Umschaltschwellenwert (Vtn) aufweist,
- die binäre Information einen geschriebenen Wert (1) aufweist, wenn die remanente Spannung (Vp) größer ist als der Umschaltschwellenwert (Vtn), und einen gelöschten Wert (0), wenn die remanente Spannung kleiner ist als der Umschaltschwellenwert und
- die Entladezeit des Speicherpunkts (CMP, C1, R1) die Haltezeit (Tp) der binären Information (Fp) in Bezug auf den Umschaltschwellenwert (Vtn) definiert.

3. Speicherzelle nach einem der Ansprüche 1 und 2, bei der die Entladezeit des Speicherpunkts (CMP, C1, R1) und die Haltezeit (Tp) der binären Information (Fp) in der Größenordnung von einigen Millisekunden bis einigen Hunderten Sekunden sind.

4. Speicherzelle nach einem der Ansprüche 1 bis 3, bei der der Detektor-Verstärkerschaltkreis (SACT) einen Umschalttransistor (T3) aufweist, der eine Steuerklemme (G) hat, die den Eingang (IN1) des Detektor-Verstärkerschaltkreises bildet und eine Schwellenspannung (Vtn) aufweist, die einen Umschaltschwellenwert des Detektor-Verstärkerschaltkreises (SACT) bildet.

5. Speicherzelle nach Anspruch 4, bei der der Umschalttransistor ein nativer MOS-Transistor mit niedriger Schwellenspannung (Vtn) ist.

6. Speicherzelle nach einem der Ansprüche 4 und 5, bei der der Detektor-Verstärkerschaltkreis (SACT) eine Umkehreingangsstufe aufweist, die den Umschalttransistor (T3) enthält, und eine Eingangsumkehrstufe (IG1), deren Eingang mit einem Knoten (N1) der Umkehrstufe verbunden ist.

7. Speicherzelle nach einem der Ansprüche 1 bis 6, bei der der Detektor-Verstärkerschaltkreis (SACT) einen Schalter (T4, IG2) aufweist, der von dem Löschsignal (RESET) gesteuert wird und eingerichtet ist, um ein elektrisches Potential (Vcc) auf einen Knoten (N1) des Detektor-Verstärkerschaltkreises anzulegen, wenn das Löschsignal (RESET) den aktiven Wert aufweist, so dass die binäre Information (Fp) auf den gelöschten Wert forciert wird.

8. Speicherzelle nach einem der Ansprüche 1 bis 7, bei der der Speicherpunkt (CMP) eine elektrische Kapazität (C1) aufweist, die mit einem Widerstand (R1) parallel geschaltet ist.

9. Speicherzelle nach Anspruch 7, bei der der Widerstand (R1) des Speicherpunkts ein parasitärer Widerstand eines MOS-Transistors (T1) ist,

10. Speicherzelle nach einem der Ansprüche 8 und 9, bei der der Widerstand ein parasitärer Widerstand eines MOS-Transistors (T1) ist, der den Schalter bildet, um das Entladen des Speicherpunkts zu verursachen.

11. Speicherzelle nach einem der Ansprüche 8 bis 10, bei der die Kapazität (C1) des Speicherpunkts eine parasitäre Gitterkapazität eines MOS-Transistors (T3) ist.

12. Speicherzelle nach einem der Ansprüche 8 bis 11, bei dem die Kapazität des Speicherpunkts die parasitäre Gitterkapazität eines MOS-Transistors (T3) des Detektor-Verstärkerschaltkreises (SA) ist, der die remanente Spannung (Vp) auf seiner Gitterklemme empfängt.

13. Integrierter Schaltkreis, **dadurch gekennzeichnet, dass** er mindestens eine Speicherzelle nach einem der Ansprüche 1 bis 12 aufweist.

14. Kontaktfreier integrierter Schaltkreis (IC, IC1-ICn), der elektrisch von einer Gleichspannung (Vcc) versorgt wird, die ausgehend von Wechselstromsignalen (S1, S2) erzeugt wird, die von einem Antennenschaltkreis (ACT, W1, W2) geliefert wird, wenn der integrierte Schaltkreis in der Gegenwart eines Aktivierungsfelds (E) ist, **dadurch gekennzeichnet, dass** er mindestens eine Speicherzelle (PVCELL) nach einem der Ansprüche 1 bis 12 aufweist, um einen Flag (Fp) während der Haltezeit (Fp) zu speichern, inklusive wenn die Gleichspannung (Vcc) verschwindet.

15. Kontaktfreier integrierter Schaltkreis nach Anspruch 14, der eine Steuereinheit (CTU) aufweist, um den Flag in die Speicherzelle (PVCELL) zu schreiben, nachdem der integrierte Schaltkreis im Laufe einer Inventurvorgehensweise identifiziert wurde, und nicht mehr auf einen Inventurbefehl (INVENTORY) zu reagieren, solange der Flag in die Speicherzelle geschrieben ist.
